**Europäisches Patentamt**

**European Patent Office**

**Office européen des brevets**

(19)

(11) Numéro de publication: **0 146 430**
**B1**

(12)

# FASCICULE DE BREVET EUROPEEN

(45) Date de publication du fascicule du brevet:
**16.09.87**

(21) Numéro de dépôt: **84402223.6**

(22) Date de dépôt: **06.11.84**

(51) Int. Cl.⁴: **H 01 L 29/64,** H 01 L 29/80

(54) Transistor à effet de champ à tension de seuil réglable, et circuit intégré comportant ce type de transistors.

(30) Priorité: **08.11.83 FR 8317724**

(43) Date de publication de la demande:
**26.06.85 Bulletin 85/26**

(45) Mention de la délivrance du brevet:
**16.09.87 Bulletin 87/38**

(84) Etats contractants désignés:
**DE GB NL**

(56) Documents cités:
**EP - A - 0 061 376**
**US - A - 4 262 296**

(73) Titulaire: **THOMSON-CSF, 173, Boulevard Haussmann, F-75379 Paris Cedex 08 (FR)**

(72) Inventeur: **Jay, Paul, THOMSON-CSF SCPI 173, bld Haussmann, F-75379 Paris cedex 08 (FR)**

(74) Mandataire: **Taboureau, James et al, THOMSON-CSF SCPI 19, avenue de Messine, F-75008 Paris (FR)**

## Description

La présente invention concerne un transistor à effet de champ, à grille Schottky, dont le canal, situé dans la couche active, entre source et drain, est fragmenté en une pluralité de tunnels, parallèles entre eux et séparés par des sillons creusés dans le matériau de la couche active. Les tunnels relient la région de couche active située sous l'électrode de source à la région de couche active située sous l'électrode de drain. La métallisation de l'électrode de grille est une bande métallique, parallèle aux électrodes de source et drain, qui épouse la surface des tunnels et des sillons: elle a, selon une coupe du transistor, la forme d'une grecque. La tension de seuil $V_T$ du transistor selon l'invention est réglable par construction, en modifiant la largeur de chaque tunnel, par une opération de masquage. La tension de seuil est donc indépendante de l'épaisseur de la couche active. Deux au moins de ces tunnels sont de largeurs différentes et ont des tensions de seuils différentes.

L'invention concerne également un transistor à caractéristique de courant de drain non linéaire.

Elle concerne enfin un circuit intégré comportant au moins deux transistors selon l'invention, ceux-ci ayant des tensions de seuils différentes, obtenues par des canaux de largeurs différentes, dans une couche active d'épaisseur constante.

Dans les transistors à effet de champ horizontaux à grille Schottky classiques, le transport de courant se fait dans l'épaisseur d'une couche de matériau semi-conducteur, dite couche active, depuis la source vers le drain. L'action de commande de la grille est obtenue en pinçant le canal conducteur entre une zone déplétée, située sous l'électrode de grille et créée par son champ électrique, et le substrat très résistif ou semi isolant. Il s'ensuit que la tension de seuil $V_T$ d'un tel tansistor est, entre autre, liée à l'épaisseur de la couche active épitaxiée sur le substrat. En effet, la zone déplétée étant située par dessus le canal, par rapport au substrat semi-isolant, la tension de polarisation correspondant au seuil d'un tel transistor est d'autant plus élevée, en valeur absolue, que la couche est épaisse, car le champ électrique correspondant au pincement est d'autant plus élevé. Ceci entraîne également que tous les transistors d'un même circuit intégré ont même tension de seuil puisque la couche active est unique et épitaxiée en une seule fois, et est, en première approximation, d'épaisseur constante.

C'est pourquoi on a cherché à contrôler un transistor à effet de champ au moyen d'une grille dont la structure — et non plus seulement le champ électrique — est établie dans l'épaisseur de la couche active. Une première solution est apportée par le document EP-A-0 061 376: selon ce document, l'électrode de grille est prolongée, en profondeur, dans la couche active par une série de puits métallisés pénétrant dans le substrat, et formant un peigne situé dans un plan normal à la direction du courant drain-source. Les zones déplétées de chaque puits métallisé contrôlent le canal conducteur latéralement, outre le zone déplétée de l'électrode de grille en surface de la pastille du transistor.

Une seconde solution est dérivée de la précédente:

elle a été exposée par R.C. Clarke, dans le document «A high efficiency castellated gate power FET» présenté à la «High Speed Semiconductor Devices and Circuits Conference» de l'Université Cornell, du 15 au 17 août 1983.

Dans ce cas, l'électrode de grille n'est plus un peigne constitué par une métallisation en surface et des «dents de peigne» qui pénètrent dans la couche active, mais elle est constituée par un ruban métallique déposé en surface et qui épouse les bords de sillons creusés dans la couche active, reconstituant ainsi un peigne métallique.

Cependant, dans les deux cas, on a cherché à mieux contrôler le courant en profondeur, et les canaux conducteurs élémentaires, entre deux «dents de peigne», ont une largeur constante. Chaque transistor a donc une tension de seuil fixée par celle de ses canaux conducteurs élémentaires, la même pour tous.

Le transistor à effet de champ selon l'invention possède la propriété d'avoir plusieurs tensions de seuils de seuils $V_T$ ajustable pour chaque transistor, indépendamment de l'épaisseur de la couche active. Selon l'invention, le canal, entre source et drain, est découpé en plusieurs canaux qui cheminent à l'intérieur de tunnels, séparés entre eux par des sillons creusés dans la couche active et légèrement plus profonds que l'épaisseur de celle-ci, de sorte que les sillons pénètrent dans le substrat semi-isolant. L'électrode de grille est une bande métallique, rectiligne et parallèle aux électrodes de source et drain lorsqu'elle est vue en plan, mais qui épouse la surface des tunnels et sillons et a donc la forme d'une grecque lorsqu'elle est vue en coupe. Les canaux, à l'intérieur des tunnels, sont donc pincés entre les trois zones déplétées créées par la métallisation de grille sur les trois faces de chaque tunnel qui n'adhèrent pas au substrat: il y a donc pincement selon un plan vertical, par opposition au pincement selon un plan horizontal, parallèle au substrat, dans les transistors à effet de champ classique.

La tension de seuil d'un transistor selon l'invention est détermimée, selon les caractériques exigées pour ce transistor dans un circuit plus complexe, par la largeur de chaque tunnel ou, corrélativement, de chaque sillon. Pour une couche active d'épaisseur donnée et de nature donnée — matériau, niveau de dopage — c'est la largeur du tunnel qui fixe la tension de seuil du canal qui traverse ledit tunnel.

Plusieurs cas d'application se présentent:

— les tunnels n'ont pas tous la même largeur, et le transistor a une caractéristique $I_D = f(V_D)$ non linéaire, parce qu'il a une pluralité de tensions de seuils,

— dans une même plaquette de circuit intégré, dont l'epaisseur de couche active est constante, les transistors ont des tensions de seuils différentes, fixées par les largeurs des tunnels.

De façon plus précise l'invention concerne un transistor à effet de champ, à grille Schottky, comportant, supportée par un substrat très résistif, une couche active et deux électrodes d'accès dites source et drain, dont la région de commande comprend une pluralité de tunnels, reliant, dans la couche active, la région située sous l'électrode de source et la région située sous l'électrode de drain, ces tunnels étant formés au moyen d'une pluralité de sillons creusés dans la couche active et plus profonds que l'épaisseur (e) de celle-ci, l'électrode de grille étant constituée par une bande métallique, déposée sur les tunnels et dans les sillons, ce transistor à effet de champ étant caractérisé en ce que deux au moins de ces tunnels sont de largeurs («l»$_1$, «l»$_2$) différentes, et ont des tensions de seuils différentes.

L'invention sera mieux comprise par la description d'un exemple de réalisation, celle-ci s'appuyant sur les figures jointes en annexes et qui représentent:

fig. 1: vue de trois quart d'un transistor à effet de champ classique, rappelant sa structure et son fonctionnement,

fig. 2: vue en coupe de la grille d'un transistor selon une première solution de l'art connu,

fig. 3: vue en coupe de la grille d'un transistor selon une seconde solution de l'art connu,

fig. 4: vue de trois quart d'un transistor à effet de champ selon la figure précédente, montrant la structure de sa région de commande,

fig. 5: vue en coupe, au niveau de la grille, d'un transistor selon l'invention,

fig. 6: coupe d'un tunnel, montrant le canal pour une première tension de grille,

fig. 7: vue en coupe d'un tunnel montrant le canal pour une deuxième tension de grille,

fig. 8: caractéristiques $I_D$ en fonction de $V_G$ d'un transistor à effet de champ associant plusieurs tunnels, de tensions de seuil $V_T$ différentes.

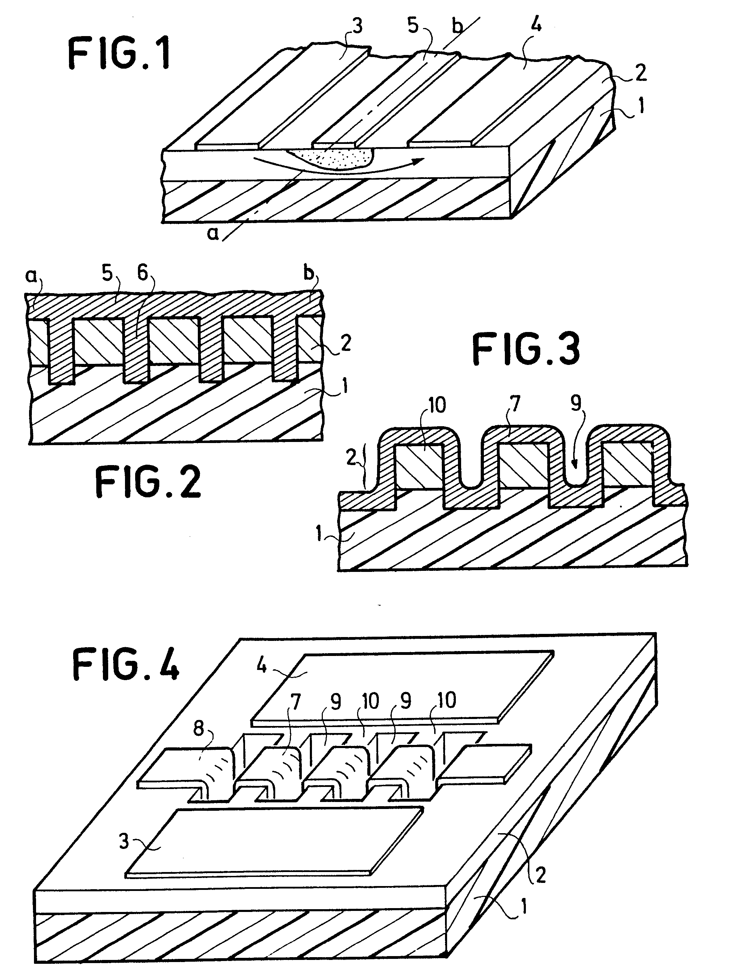

La fig. 1 représente une vue de trois quart dans l'espace d'un transistor à effet de champ classique, et elle rappelle sa structure en même temps que son fonctionnement.

Un transistor à effet de champ est généralement constitué d'un substrat 1 très résistif ou semi-isolant sur lequel est épitaxiée une couche 2 d'un matériau semi-conducteur: c'est dans cette couche 2 dite couche active qu'a lieu le transport de courant entre les électrodes d'accès, dites de source 3 et de drain 4. Le contrôle du transport de courant depuis la source vers le drain est opéré au moyen d'une électrode de grille 5 qui est très généralement une bande métallique plate, déposée sur la surface de la couche active, parallèle, selon l'axe ab, aux électrodes de source et de drain. Sous l'action de la tension de commande appliquée sur l'électrode de grille 5, le champ électrique crée une zone déplétée, située sous l'électrode de grille, et qui déborde légèment les dimensions de l'électrode de grille, en direction de la source et du drain. Le courant électrique passe d'une première électrode d'accès à une seconde électrode d'accès par un canal, symbolisé par une flèche sur la fig. 1, et ce canal est plus ou moins pincé, selon la tension de grille $V_G$, entre la zone déplétée et le substrat très résistif ou semi-isolant 1. Par conséquent, la tension de seuil, c'est-à-dire la tension à partir de laquelle le transistor est rendu conducteur, ou au contraire est bloqué, dépend, entre autres phénomènes, de l'épaisseur de la couche active 2, puisque pour une même tension de grille $V_G$, la zone déplétée a toujours les mêmes dimensions. Donc un transistor qui a une couche active 2 plus épaisse qu'un autre transistor dont la couche active 2 est fine a une tension de seuil plus élevée que ce dernier.

Ceci entraîne une valeur de tension de seuil unique pour tous les transistors réalisés simultanément, c'est-à-dire par exemple pour tous les transistors d'un même circuit intégré. Pour avoir deux transistors à tensions de seuils différentes il faut opérer deux masquages et deux dépôts différents pour les grilles, ce qui n'est pas recherché pour la réalisation de circuits intégrés.

Au contraire, dans la réalisation d'un circuit intégré, et quelles que soient les précautions prises, il arrive que l'épaisseur de la couche active ne soit pas rigoureusement constante: il s'ensuit que les transistors réalisés n'ont pas tous la même tension de seuil, ce qui peut poser des problèmes d'uniformité s'il est nécessaire que tous les transistors aient même tension de seuil dans la réalisation de grands circuits logiques par exemple.

La fig. 2 représente une vue en coupe de la grille d'un transistor selon le document EP-A-0 061 376 précité.

La coupe y est effectuée selon l'axe ab de la figure précédente, c'est-à-dire que les régions de source et de drain du transistor sont de part et d'autre du plan de la figure.

Selon cette demande de brevet, des puits sont creusés dans la couche active 2 d'un transistor, suffisamment profonds pour atteindre le substrat 1 dans lequell ils pénètrent partiellement. La fig. 2 ne représente qu'une seule couche active, mais, bien entendu, si celle-ci est composée de plusieurs couches, et qu'il y a en outre une couche de lissage sur le substrat, toutes ces couches sont percées par les puits. L'électrode de grille est constituée par une métallisation Schottky, qui remplit les puits: elle a donc la forme d'un peigne, comprenant une métallisation 5, en ruban, déposée sur la surface libre de la couche active 2, et des «dents de peigne» 6, qui découpent le canal conducteur en une pluralité de canaux conducteurs élémentaires.

Pour chaque canal conducteur élémentaire, le courant est pincé, en partie verticalement par rapport au substrat par la métallisation 5, mais surtout horizontalement, entre deux « dents de peigne» 6.

La fig. 3 représente une vue en coupe de la grille d'un transistor mettant en oeuvre les mêmes moyens de contrôle horizontal du canal conducteur que celui de la figure précédente. La coupe de la fig. 3 est effectuée selon le même axe ab que sur les figures 1 et 2.

Dans un transistor qui comprend au moins un substrat 1 et une couche active 2, des sillons sont creusés dans la couche active, assez profonds pour entamer dans le substrat. Ces sillons 9 sont orientés selon une direction orthogonale au plan de la figure, allant de la région de souce vers la région de drain. Ils séparent la couche active 2 en une pluralité de tunnels ou canaux conducteurs élémentaires 10, dans lesquells le courant est pincé en partie horizontalement et en partie verticalement, comme dans l'exemple précédent, sous l'action du champ électrique développé par une métallisation 7, constituant la grille, en forme de ruban déposé sur les trois faces libres des canaux conducteurs 10 et sur le substrat 1, dans le fond des sillons 9.

Dans les deux cas de figures 2 et 3, les puits 6 et les sillons 9 sont régulièrement espacés, de telle sorte que le courant source-drain soit bien contrôlé. La différence entre les deux cas provient de ce que les puits 6 ont une petite largeur, qui ne permet pas de métalliser leurs bords seulement, tandis que les sillons 9 sont assez larges pour qu'il soit possible de métalliser leurs bords et leur fond. En outre, les puits 6 sont de section ronde ou carrée — vue dans un plan horizontal par rapport au substrat — tandis que les sillons 9 ont longueur définie, comme le montre la fig. 4.

Celle-ci représente une vue de trois quart dans l'espace d'un transistor selon l'art connu, doté de la grille de la fig. 3 qui est ainsi mieux expliquée.

Ce transistor possède un substrat 1 très résistif ou semi-isolant sur lequel est épitaxiée une couche de matériau semi-conducteur 2 dite couche active. Dans l'espace entre les électrodes de source et de drain 3 et 4, déposées en surface de la couche active 2, un système de sillons 9 est creusé. Ces sillons sont creusés dans le sens de la largeur de la grille, c'est-à-dire qu'ils sont perpendiculaires aux bords face à face des deux électrodes de source et de drain 3 et 4. Ces sillons sont séparés entre eux par des régions 10 de la couche active qui sont réservées par masquage au cours des opérations de creusement des sillons 9. Ces régions 10 forment donc des tunnels qui, dans l'épaisseur de la couche active, relient la région de couche active située sous l'électrode de source 3 à la région de couche active située sous l'électrode de drain 4.

L'électrode de grille 7 est une bande métallique parallèle aux électrodes de source et de drain, c'est-à-dire qu'elle a, vue en plan, la même orientation selon l'axe ab que l'électrode de grille 5 de la fig. 1. Mais en raison de la présence des sillons 9, cette électrode de grille épouse les parois et le fond des sillons 9 et des tunnels 10, de sorte que, vue en coupe, cette électrode a la forme d'une grecque. Le contact électrique est pris sur une métallisation 8, déposée sur la couche active à côté de la région des sillons et des tunnels. De plus, la bande constituant l'électrode de grille 7 a une largeur inférieure à la longueur des canaux, de façon à bien délimiter la zone déplétée à l'intérieur de chaque tunnel. Mais, chaque tunnel ayant même largeur que les autres tunnels, la tension de seuil $V_T$ de ce transistor est fixe et unique.

La fig. 3 représente une vue en coupe, au niveau de la grille, d'un transistor selon l'invention.

La couche active 2 ayant une épaisseur e, les sillons 9 sont creusés sur une profondeur p, supérieure à l'épaisseur e épitaxiée, de telle sorte que les tunnels 10 se trouvent isolés, et supportés dans l'espace par une faible épaisseur de substrat semi-isolant, mais il n'y a pas, entre les bases de deux tunnels 10 voisins une couche de matériau semi-conducteur 2 qui pourrait les courtcircuiter.

Par ailleurs, les tunnels 10 ont une configuration perpendiculaire par rapport à la surface du substrat 1, et ils sont taillés de telle façon que leur longueur L se trouve selon l'axe de transport du courant depuis la source vers le drain. Par conséquent, leur longueur L correspond bien à ce qu'il est convenu d'appeler la longueur d'une grille, mesurée depuis la source vers le drain. La largeur «l» des tunnels 10 est obtenue en fonction du masquage: c'est elle qui règle la tension de seuil à travers un tunnel donné d'un transistor, comme cela est montré sur les figures suivantes. Etant donné que la largeur «l» d'un tunnel 10 ne dépend plus de l'épaisseur e de la couche active, mais uniquement du masquage qui a été réalisé pour creuser les sillons 9, il est possible pour un même transistor, ou pour les différents transistors d'un circuit intégré, de masquer, au cours d'une même opération, des tunnels qui ont des largeurs «l» différentes.

Deux cas sont possibles.

Tous les tunnels d'un même transistor ont même largeur «l», définissant pour ce transistor une tension de seuil donnée. Mais, pour une plaquette de circuit intégré, dotée d'une couche 2 d'épaisseur donnée, et constante sur toute la plaquette, il est possible de réaliser des transistors à effet de champ qui ont des tensions de seuil différentes. Il suffit de creuser les sillons 9 d'un transistor laissant entre eux des tunnels 10 dont la largeur «l» correspond à la tension de seuil voulue pour ce transistor puisque la tension de seuil est désormais fonction d'une largeur horizontale «l» et non plus d'une épaisseur e de couche épitaxiée. Ainsi, le masque de creusement des sillons est doté de réseaux de motifs correspondant aux différentes tensions de seuils nécessaires pour ce circuit intégré.

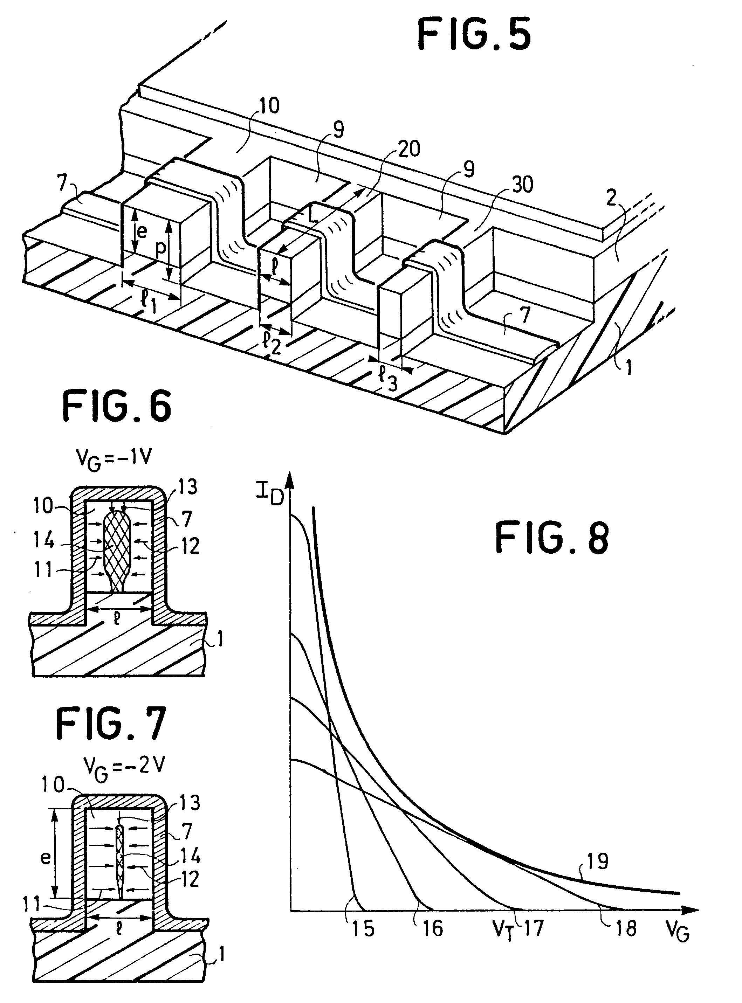

Le second cas est celui de l'invention représentée à titre d'exemple en fig. 5, selon laquelle les tunnels d'un même transistor ont des largeurs «l» différentes entre eux: «l»$_1$, «l»$_2$, «l»$_3$.

A titre d'exemple, non limitatif de l'invention, trois tunnels 10, 20 et 30 sont représentés sur la coupe de transistor de la fig. 5: le tunnel 10 a une largeur plus grande que celle du tunnel 20, lui-même plus large que le tunnel 30. A chacune de ces largeurs correspond une tension de seuil, ou de pincement, comme cela sera expliqué à l'occasion des figures 6 et 7. La coopération de plusieurs tunnels de largeurs différentes permet d'ajuster ou de modifier la tension de seuil d'un transistor, pour une épaisseur donnée de couche active 2.

Les figures 6 et 7 représentent une coupe d'un même tunnel 10, correspondant à deux polarisations de grille différentes, c'est-à-dire à titre d'exemple -1 Volt en fig. 6 et -2 Volts en fig. 7.

Le matériau semiconducteur du tunnel 10 étant supporté par le substrat 1 semi-isolant ou très résistif, le tunnel se trouve «coiffé» par une métallisation de grille Schottky 7. L'interface entre le tunnel 10 et le substrat 1 n'intervient pas, mais les zones déplétées, créées par le champ électrique de la grille Schottky sont représentées symboliquement par des flèches 11 et 12 pour les deux zones déplétées verticales par rapport au substrat et 13 pour la zone déplétée supérieure. La longueur des flèches 11, 12 et 13 est proportionnelle à la profondeur de la zone déplétée correspondante, et par conséquent à la tension de grille. Le canal 14 se trouve donc pincé, essentiellement entre deux zones déplétées 11 et 12, et la tension de seuil n'est plus proportionnelle à l'épaisseur de la couche épitaxiée 2. Telles que sont faites ces coupes des figures 6 et 7, l'épaisseur de la couche épitaxiée 2 correspond à la hauteur du tunnel 10 sur chacune de ces figures: dans le transistor selon l'invention, la tension de seuil est liée à la largeur 1, c'est-à-dire qu'elle est réglable par masquage.

Ainsi, on voit que sur la fig. 6, pour une tension de grille VG = -1 Volt, le canal 14 correspond à un passage notable de courant, le transistor étant conducteur. Par contre, sur la fig. 7, pour une tension VG = -2 Volts, le canal 14 est très pincé, et le transistor presque complètement bloqué. L'action d'un champ électrique, et l'épaisseur d'une zone de déplétion étant fonction du matériau du tunnel 10, le réglage de l'état bloqué, c'est-à-dire le réglage de la tension de seuil d'un tunnel dépend uniquement de sa largeur «l», et par conséquent des conditions de masquage du tunnel ou ce qui revient au même du creusement des sillons 9 entre tunnels 10.

La tension de seuil n'étant, dans ce type de transistor, plus proportionnelle à l'épaisseur de la couche épitaxiée, mais à la tension de grille pour une largeur donnée de tunnel, la réciproque est que trois tunnels tels que 10, 20 et 30, sur la fig. 5, qui ont des largeurs différentes, ont des tensions de seuils différentes, d'autant plus élevées, en valeur absolue, que le tunnel est plus large.

La fig. 8 montre l'intérêt qu'il y a à disposer pour un même transistor de plusieurs tunnels conducteurs.

Cette figure représente la caractéristique de courant de drain $I_D$ en fonction de la tension de grille $V_G$. Pour un transistor à effet de champ donné, ou pour un tunnel 10 donné, cette caractéristique est généralement une droite, qui recoupe l'axe des tensions de grille en un point appelé la tension de seuil $V_T$. Un transistor à effet de champ a donc généralement une courbe de caractéristiques qui est une droite (entre certaines limites d'opération). Si un transistor selon l'invention est doté d'une pluralité de tunnels 10, ayant des largeurs «l» différentes, et par conséquent des tensions de seuil différentes, il correspond à la mise en parallèle d'une pluralité de transistors à effet de champ qui ont des caractéristiques $I_D/V_G$ différentes. C'est ce que représente la fig. 8 sur laquelle on a pris à titre d'exemple quatre tunnels ayant des tensions de seuil différentes 15, 16, 17 et 18. L'enveloppe de ces courbes de caractéristiques linéaires donne une courbe 19 qui n'est pas linéaire. Par conséquent, il est possible en choisissant le nombre de tunnels et leur tension de seuil, c'est-à-dire en choisissant les largeurs de masquage, d'obtenir pour un transistor donné la courbe de caractéristiques que l'on veut: puissance «n»ième ou racine, logarithmique ou exponentielle...etc.

Une conséquence de ceci concerne le nombre de tunnels qu'il faut mettre en parallèle pour réaliser un transistor de caractéristiques données. Chaque tunnel a un courant de drain $I_D$ inversement proportionnel à sa tension de seuil $V_T$: par exemple, sur la fig. 8 le courant de drain de la courbe 15 est sensiblement le double de celui de la caractéristique 17, à $V_G$ = 0. Par conséquent, le nombre de tunnels d'un type donné, ayant une tension de seuil donnée, permet de contrôler le courant de saturation. Ainsi, la coopération de groupes de tunnels, de plusieurs types, permet de contrôler la caractéristique $I_D$ = f $(V_G)$ d'un transistor.

Les avantages du transistor selon l'invention sont:

— une meilleure transconductance due au fait que le contrôle du canal se fait entre deux zones de déplétion, plutôt qu'entre une seule zone et l'interface couche active/substrat, comme dans les transistors à effet de champ classiques,

— une meilleure dissipation thermique, due à la surface importante pour une grille donnée, cette dissipation thermique étant intéressante pour l'application aux transistors de puissance,

— la diminution de la résistance d'accès, grâce au rapport entre la quantité de matériau semiconducteur qui se trouve dans les différents tunnels 10, et la largeur importante de matériau qui reçoit les contacts ohmiques,

— le réglage à volonté, par simple masquage, de la tension de seuil $V_T$, qui n'est plus fonction de l'épaisseur de la couche active, ce qui permet de réaliser, au cours d'une même opération de fabrication de circuits intégrés par exemple, des transistors ayant des tensions de seuil différentes.

Une légère augmentation de la capacité parasite de source-grille peut provenir du fait qu'il existe une partie parasite de la grille 7 déposée sur le matériau semiisolant du substrat entre chaque élément d'une grille à plusieurs sillons. Cependant, l'expérience montre que cette contribution est faible devant la capacité source-grille due à la diode formée entre la métallisation Schottky 7 de grille et la couche active de types divers.

Le transistor à effet de champ selon l'invention peut être réalisé dans différents matériaux du type GaAs, InP, ou plus généralement les composés des familles III-V. Il peut également être réalisé en silicium, mais comme on ne sait pas réaliser des substrats de silicium semi-isolant, tandis qu'on sait le faire avec les matériaux de type GaAs ou InP, le substrat de silicium peut être remplacé par un substrat de saphyr, ou bien alors recouvert d'une couche fortement isolante par implantation, ou de deux couches formant jonction, l'important étant de localiser le passage du courant dans une couche active.

Cette couche active a une particularité qui est d'être légèrement plus épaisse que les couches actives généralement rencontrées dans les transistors classiques, de telle façon que l'on puisse y creuser les sillons 9.

Ceux-ci sont creusés en utilisant de préférence un masquage multicouche, afin d'atteindre un profil vertical plus régulier que par un masquage avec une seul couche de résine. Le masquage multicouche, bien connu, est essentiellement composé d'une couche de résine photosensible, ou électro-sensible, déposée sur une couche d'un matériau intermédiaire tel que germanium, lui-même déposé sur une couche épaisse de polyimide, qui fait par exemple trois µm d'épaisseur. L'avantage du masquage multicouche est qu'il diminue les effets secondaires des photons ou des électrons rétrodiffusés par le substrat, et que par conséquent ceci permet d'obtenir des parois pour les caissons 9 et les sillons 10 qui sont plus nettes et plus verticales. C'est parce que les tunnels conducteurs entre source et drain passent dans l'épaisseur de la couche active, et que le pincement a lieu selon un plan vertical par rapport au substrat, que la couche active 2 doit nécessairement être plus épaisse que dans un transistor à effet de champ classique.

C'est également par masquage multicouche qu'est définie la grille, le masquage multicouche permettant de bien suivre le contour de la surface en forme de grecque constitée par les tunnels et les sillons. Pour déposer une électrode de grille régulière, il est nécessaire d'utiliser une méthode isotropique telle que la pulvérisation, qui permet de déposer du métal aussi bien sur les parois des sillons que dans le fond. Le ou les métaux choisis pour réaliser la grille Schottky dépendent de la nature du semi-conducteur, c'est par exemple de l'aluminium ou l'alliage Ti-Pt-Au si le transistor est en GaAs.

La méthode de réalisation d'un transistor selon l'invention comporte donc les étapes suivantes:

a) sur un substrat en matériau très résistif ou semi-isolant, faire croître une couche épitaxiée de 1,5 à 2 μm d'épaisseur. Si le substrat est in GaAs, la couche épitaxiée est en GaAs très peu dopée n ($5 \cdot 10^{16} cm^{-3}$),

b) réaliser les contacts ohmiques de source et de drain, à la surface libre de la couche active, par un procédé classique, ces métallisations étant par exemple Au-Ge/Ni-Au déposées par évaporation suivi d'un recuit à 450°. Ces métallisations sont espacées entre elles d'environ 5 μm,

c) dans l'espace source-drain de 5 μm de longueur, et par masquage multicouche suivi d'une attaque isotronique par gravure ionique, creuser des caissons dans la surface de la couche active, chaque caisson ayant des dimensions d'environ 1,5 × 1,5 μm une profondeur de 2 microns, les tunnels séparant les caissons ayant environ 0,5 μm de large, selon la tension de seuil désirée,

d) par masquage multicouche, afin de bien épouser la surface des caissons et des tunnels, réaliser une ouverture d'environ 0,7 micron de largeur, cette ouverture étant parallèle au bord des contacts ohmiques, et déposer par un procédé isotropique telle la pulvérisation cathodique ou par croissance électrolytique, une métallisation de grille sur la surface des tunnels et dans le fond des caissons. Cette métallisation de grille est en aluminium ou Ti-Pt-Au si le matériau est en GaAs.

Le transistor selon l'invention trouve son application notamment dans les circuits intégrés nécessitant des tensions de seuils différentes, ainsi que dans les transistors discrets, de puissance ou à caractéristiques spéciales.

## Revendications

1. Transistor à effet de champ, à grille Schottky, comportant, supportée par un substrat (1) très résistif, une couche active (2) et deux électrodes d'accès (3,4) dites source et drain, dont la région de commande comprend une pluralité de tunnels (10, 20, 30) reliant, dans la couche active (2), la région située sous l'électrode de source (3) et la région située sous l'électrode de drain (4), ces tunnels étant formés au moyen d'une pluralité de sillons (9) creusés dans la couche active (2) et plus profonds (p) que l'épaisseur (e) de celle-ci, l'électrode de grille (7) étant constituée par une bande métallique, déposée sur les tunnels (10, 20, 30) et dans les sillons (9), ce transistor à effet de champ étant caractérisé en ce que deux au moins de ces tunnels (10, 30) sont de largeurs («l»$_1$, «l»$_3$) différentes, et ont des tensions de seuils ($V_T$) différentes.

2. Transistor à effet de champ selon la revendication 1 caractérisé en ce qu'une caractéristique non-linéaire de courant de drain en fonction de la tension de grille $I_D = f (V_G)$ est obtenue pour ce transistor au moyen de plusieurs tunnels (10, 20, 30), travaillant en parallèle, de tensions de seuils ($V_T$) différentes et de largeurs («l») différentes.

3. Transistor à effet de champ selon la revendication 2, comportant plusieurs groupes de tunnels, chaque groupe ayant une tension de seuil différente, caractérisé en ce que la forme de sa caractéristique non-linéaire de courant de drain en fonction de la tension de grille $I_D = f (V_G)$ est déterminée par le nombre des tunnels (10, 20, 30), dans chaque groupe de tunnels ayant même tension de seuil ($V_T$), ce nombre déterminant le courant de saturation du transistor pour la tension de grille ($V_G$).

4. Transistor à effet de champ selon la revendication 1 caractérisé en ce que le matériau semi-conducteur dans lequel il est réalisé est un composé de la famille III-V (GaAs, InP...), très résistif ou semi-isolant pour le substrat (1), et peu dopé ($5 \cdot 10^{16}$ cm$^{-3}$) de type n pour la couche active (2), et en ce que la métallisation de grille (7) est en Al ou Ti-Pt-Au et les métallisations de source et drain (3,4) en Au-Ge/Ni-Au.

5. Transistor à effet de champ selon la revendication 1 caractérisé en ce que la couche active (2) étant en silicium, le substrat (1) est en saphyr ou en silicium rendu isolant par une jonction p/n ou par implantation.

6. Circuit intégré, caractérisé en ce qu'il comporte au moins deux transistors selon la revendication 1, les tensions de seuils ($V_T$) de ces transistors étant différentes en raison des largeurs («l») différentes de leurs tunnels (10) dans la couche active.

## Patentansprüche

1. Feldeffekttransistor mit Schottky-Gate, welcher auf einem hochresistiven Substrat (1) eine aktive Schicht (2) und zwei Zugangselektroden (3, 4) enthält, die als Source und Drain bezeichnet werden, und dessen Steuergebiet mehrere Tunnels (10, 20, 30) enthält, welche innerhalb der aktiven Schicht (2) das unter der Sourceelektrode (3) liegende Gebiet und das unter der Drainelektrode (4) liegende Gebiet verbinden, wobei diese Tunnels durch mehrere Rillen (9) gebildet sind, welche in die aktive Schicht (2) eingesenkt sind und tiefer sind (p) als die Dicke (e) derselben wobei die Gateelektrode (7) durch einen metallischen Streifen gebildet ist, welcher auf den Tunnels (10, 20, 30) und in den Rillen (9) aufgebracht ist, wobei dieser Feldeffekttransistor dadurch gekennzeichnet ist, dass wenigstens zwei der Tunnels (10, 30) verschiedene Breiten («l»$_1$, «l»$_3$) und verschiedene Schwellspannungen ($V_T$) aufweisen.

2. Feldeffekttransistor nach Anspruch 1, dadurch gekennzeichnet, dass eine nichtlineare Kennlinie des Drainstromes in Abhängigkeit von der Gatespannung $I_D = f (V_G)$ für diesen Transistor mittels mehrerer parallel arbeitender Tunnels (10, 20, 30) von verschiedenen Schwellspannungen ($V_T$) und verschiedenen Breiten («l») erhalten wird.

3. Feldeffekttransistor nach Anspruch 2, mit mehreren Gruppen von Tunnels, wobei jede Gruppe eine verschiedene Schwellspannung aufweist, dadurch gekennzeichnet, dass die Form seiner nichtlinearen Kennlinie des Drainstromes in Abhängigkeit von der Gatespannung $I_D = f (V_G)$ durch die Anzahl von Tunnels (10, 20, 30) bestimmt ist, wobei in jeder Gruppe von Tunnels mit gleicher Schwellspannung ($V_T$) diese Anzahl den Sättigungsstrom des Transistors für die Gatespannung ($V_G$) bestimmt.

4. Feldeffekttransistor nach Anspruch 1, dadurch gekennzeichnet, dass das Halbleitermaterial, worin er gebildet ist, eine Verbindung aus der Gruppe III-V (GaAs, InP...) ist, welche für das Substrat (1) hochresistiv oder halbisolierend und für die aktive Schicht (2) schwach n-dotiert ($5 \cdot 10^{16} cm^{-3}$) ist, und dass die Gate-Metallisierung (7) aus Al oder Ti-Pt-Au besteht und die Source- und Drain-Metallisierungen (3, 4) aus Au-Ge/Ni-Au bestehen.

5. Feldeffekttransistor nach Anspruch 1, dadurch gekennzeichnet, dass die aktive Schicht (2) aus Silicium besteht, das Substrat (1) aus einem Saphir oder aus Silicium besteht, welches durch einen p/n-Übergang oder durch Implantation isolierend gemacht wurde.

6. Integrierte Schaltung, dadurch gekennzeichnet, dass sie wenigstens zwei Transistoren nach Anspruch 1 enthält, wobei die Schwellspannungen (VE) dieser Transistoren aufgrund verschiedener Breiten («l») ihrer Tunnels (10) in der aktiven Schicht verschieden sind.


**Claims**

1. Field effect transistor having a Schottky gate and comprising as carried by a highly resistive substrate (1) an active layer (2) and two access electrodes (3, 4) referred to as source and drain, the control region of which comprises a plurality of tunnels (10, 20, 30) connecting within the active layer (2) the region located beneath the source electrode (3) and the region located beneath the drain electrode (4), these tunnels being formed by means of a plurality of grooves (9) which are worked into the active layer (2) and have a depth (p) exceeding the thickness (e) of the latter, the gate electrode (7) being formed by a metallic strip deposited onto the tunnels (10, 20, 30) and in the grooves (9), this field effect transistor being characterized in that at least two of these tunnels (10, 30) have different lengths («l»$_1$, «l»$_3$) and have different threshold voltages ($V_T$).

2. Field effect transistor according to claim 1, characterized in that a non-linear characteristic of the drain current as a function of the gate voltage $I_D = f (V_G)$ is obtained for this transistor by means of a plurality of tunnels (10, 20, 30) functioning in parallel and having different threshold voltages ($V_T$) and different lengths («l»).

3. Field effect transistor according to claim 2, comprising a plurality of groups of tunnels, each group having a different threshold voltage, characterized in that the shape of its non-linear characteristic of the drain current as a function of the gate voltage $I_D = f (V_G)$ is determined by the number of tunnels (10, 20, 30), this number determining in each group of tunnels having the same threshold voltage ($V_T$) the saturation current of the transistor for the gate voltage ($V_G$).

4. Field effect transistor according to claim 1, characterized in that the semiconductor material wherein it is embodied is a composition of the group III-V (GaAs, InP...) which is highly resistive or semiinsulating in the substrate (1) and slightly n doped ($5 \cdot 10^{16} cm^{-3}$) in the active layer (2) and in that the gate metallization (7) is of Al or Ti-Pt-Au, and the source and drain metallizations (3, 4) are of Au-Ge/Ni-Au.

5. Field effect transistor according to claim 1, characterized in that the active layer (2) is of silicon, the substrate (1) being of saphire or silicon rendered insulating by a p/n junction or by implantation.

6. Integrated circuit, characterized in that it comprises at least two transistors according to claim 1, threshold voltages ($V_T$ of these transistors being different in view of different lengths («l») of their tunnels (10) in the active layer.

0 146 430

FIG.1

FIG.2

FIG.3

FIG.4

9

# FIG.5

# FIG.6

$V_G = -1V$

# FIG.7

$V_G = -2V$

# FIG. 8